(19) Europäisches Patentamt / European Patent Office / Office européen des brevets

(11) **EP 4 369 008 B1**

(12) **EUROPÄISCHE PATENTSCHRIFT**

(45) Veröffentlichungstag und Bekanntmachung des Hinweises auf die Patenterteilung:
**01.10.2025 Patentblatt 2025/40**

(21) Anmeldenummer: **23203212.8**

(22) Anmeldetag: **12.10.2023**

(51) Internationale Patentklassifikation (IPC):
**G01R 31/52** *(2020.01)* **G01R 27/02** *(2006.01)*
**G01R 31/58** *(2020.01)*

(52) Gemeinsame Patentklassifikation (CPC):
**G01R 31/52; G01R 27/025; G01R 31/58**

(54) **VERFAHREN UND ELEKTRISCHE SCHALTUNGSANORDNUNG ZUR ZWEIGSELEKTIVEN BESTIMMUNG RESISTIVER UND KAPAZITIVER, ISOLATIONSBESTIMMENDER GRÖSSEN IN EINEM VERZWEIGTEN UNGEERDETEN STROMVERSORGUNGSSYSTEM**

METHOD AND ELECTRIC CIRCUIT ARRANGEMENT FOR BRANCH-SELECTIVE DETERMINATION OF RESISTIVE AND CAPACITIVE INSULATION-DETERMINING VARIABLES IN A BRANCHED UNEARTHED POWER SUPPLY SYSTEM

PROCÉDÉ ET AGENCEMENT DE CIRCUIT ÉLECTRIQUE POUR DÉTERMINER SÉLECTIVEMENT PAR BRANCHE DES VARIABLES RÉSISTIVES ET CAPACITIVES D'ISOLATION DANS UN SYSTÈME D'ALIMENTATION ÉLECTRIQUE RAMIFIÉ ET SANS MISE À LA TERRE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **25.10.2022 DE 102022128107**

(43) Veröffentlichungstag der Anmeldung:
**15.05.2024 Patentblatt 2024/20**

(73) Patentinhaber: **Bender GmbH & Co. KG**
**35305 Grünberg (DE)**

(72) Erfinder: **REITZ, Julian**
**35305 Grünberg (DE)**

(74) Vertreter: **advotec.**
**Patent- und Rechtsanwaltspartnerschaft mbB**
**Georg-Schlosser-Straße 6**
**35390 Gießen (DE)**

(56) Entgegenhaltungen:
DE-A1- 102013 218 836    DE-A1- 102015 216 915
DE-B3- 102017 217 473

# EP 4 369 008 B1

**Beschreibung**

Die Erfindung betrifft ein Verfahren und eine elektrische Schaltungsanordnung zur zweigselektiven Bestimmung resistiver und kapazitiver, isolationsbestimmender Größen (Isolationswiderstand und Ableitkapazität) in einem verzweigten ungeerdeten Stromversorgungssystem mit Isolationsüberwachung.

Ungeerdete Stromversorgungssysteme (Stromnetze) müssen gemäß DIN VDE 0100-410 mit einem Isolationsüberwachungsgerät (IMD - Insulation Monitoring Device) nach DIN EN 61557-8 ausgestattet sein.

Das Isolationsüberwachungsgerät ist an zentraler Stelle nahe des Einspeisepunktes in dem Hauptsystem des Stromversorgungssystems angeordnet und erfasst normgemäß den Isolationswiderstand (resistiver oder ohmscher Anteil einer Isolationsimpedanz) sowie, je nach Geräteausstattung, zusätzlich auch die Ableitkapazität (kapazitiver Anteil der Isolationsimpedanz) der ungeerdeten elektrischen Anlage gegen Erdpotential (Erde).

Dazu weist das Isolationsüberwachungsgerät einen Messpfad zwischen mindestens einem aktiven Leiter des Stromversorgungssystems und Erde auf, über den mittels einer Messspannungsquelle eine Messspannung erzeugt und über einen Ankoppelwiderstand in das Stromversorgungssystem eingespeist wird (aktives Messverfahren). An einem Messwiderstand wird der in dem Messpfad von der Messspannung getriebene und sich entsprechend des Isolationsfehlers einstellende (Mess-)Strom als Spannungsabfall (gemessene Spannung) gemessen und in einer IMD-Auswerteelektronik ausgewertet.

Treten ohmsche Isolationsfehler auf, so löst das Isolationsüberwachungsgerät einen Alarm aus, sobald der Isolationswiderstand einen einstellbaren, an das Stromversorgungssystem angepassten Ansprechwert unterschreitet.

Aus der Kombination der isolationsbestimmenden Größen Isolationswiderstand und Ableitkapazität kann der Fachmann wichtige Schlüsse hinsichtlich des Isolationszustandes und der Schutzwirkung des ungeerdeten Stromversorgungssystems ziehen.

Um der normativen Forderung nach einer schnellen Beseitigung des Isolationsfehlers nachzukommen und den Isolationsfehler in einem verzweigten, aus Hauptsystem und (Leitungs-)Zweigen (Leitungsabgängen) bestehenden Stromversorgungssystem zu lokalisieren, werden Isolationsfehler-Sucheinrichtungen (IFLS - Insulation Fault Location System) gemäß DIN EN 61557-9 verwendet.

Aus dem Stand der Technik sind Lösungen der Fehlersuche bekannt, die darauf abzielen, Leitungszweige mit niedrigem ohmschen Isolationsniveau zu lokalisieren, beispielsweise die Suche nach dem Leitungszweig mit dem größten Gleichtakt-Fehlerstrom-Anteil. Dazu wird an das ungeerdete Stromnetz ein Prüfstromgenerator angeschlossen, welcher zwischen mindestens einen aktiven Leiter und Erdpotential einen netzgetriebenen oder lokal generierten Prüfstrom im mA-Bereich einprägt.

Im Unterschied zu dem bei der Isolationswiderstands-Messung durch das Isolationsüberwachungsgerät eingespeisten Messstrom wird der bei der Isolationsfehlersuche eingespeiste Strom als Prüfstrom bezeichnet. Allerdings kann, wie aus der vorliegenden Erfindung in vorteilhafter Weise hervorgeht, der Messstrom des Isolationsüberwachungsgerätes in der Funktion als Prüfstrom zur Isolationsfehlersuche und erfindungsgemäß zur zweigselektiven Bestimmung der resistiven und kapazitiven, isolationsbestimmenden Größen verwendet werden.

Mittels der Isolationsfehler-Sucheinrichtung erfolgt also eine Stromanregung des Stromversorgungssystems mit einem Prüfstrom, vorzugsweise mit rechteckförmiger Signalform, wobei die Grundfrequenz der Rechteckanregung im einstelligen oder im Sub-Hertz Bereich liegt. Der Prüfstromgenerator kann dabei innerhalb eines Isolationsüberwachungsgeräts angeordnet sein und ist in der Regel netzgetrieben. Damit die Anregung störungsfrei überlagert und rückgemessen werden kann, muss die Grundfrequenz des Prüfstroms an die durch die resistiven und kapazitiven Größen bestimmten Tiefpasseigenschaften und die daraus resultierende Systemfrequenz des Stromversorgungssystems angepasst sein.

Der oder die zu überwachenden Leitungszweig(e) des Stromnetzes werden jeweils mit einem Sensor (CT - Current Transformer), bestehend aus einem (Ringkern-)Messstromwandler mit Sekundärwicklung überwacht, wobei der durch den Ringkern des Messstromwandlers geführte Leitungszweig als Primärwicklung mit (nur) einer Windung wirkt. Liegt nun in diesem Leitungszweig ein Isolationsfehler vor, so fließt durch den Messstromwandler des Sensors ein (Gleichtakt-)Zweigstrom, der auf die Sekundärseite transformiert wird und als Sekundärstrom einer Auswertung zugänglich ist.

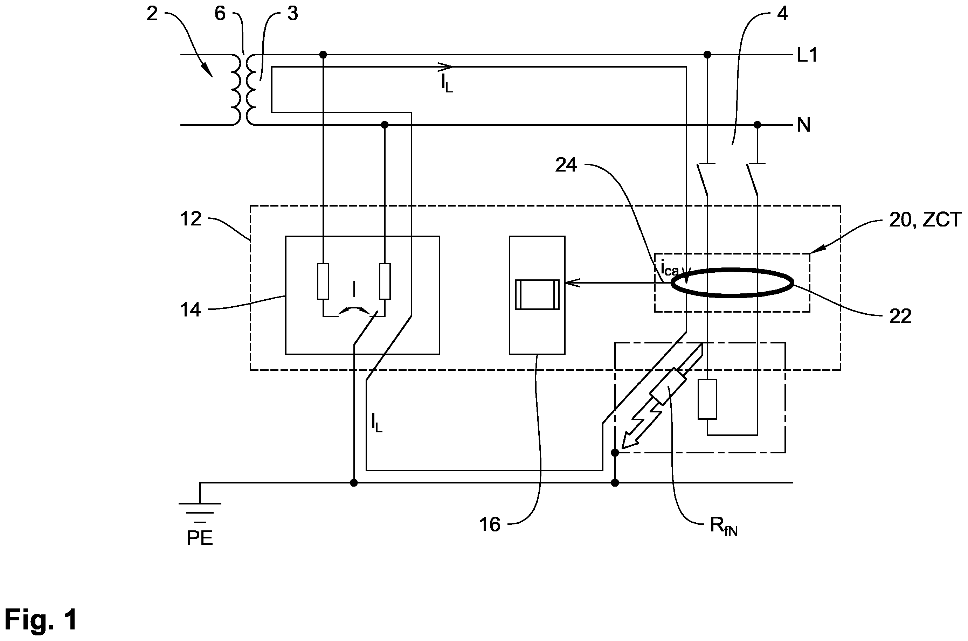

Eine Lösung nach vorgenanntem Verfahren mit Einspeisung eines Prüfstroms durch einen Prüfstromgenerator wird von der Fa. Bender GmbH & Co. KG angeboten und ist in Fig. 1 schematisch dargestellt.

Mit diesem Verfahren können fehlerhafte Leitungszweige lokalisiert werden, jedoch lässt sich keine direkte Aussage zur Größe des Isolationswiderstands und der Ableitkapazität treffen.

Eine weitere Lösung wird in der Offenlegungsschrift EP 1 589 345 A1 beschrieben. Die Einstellung eines in einem separaten Prüfstromgenerator erzeugten Prüfwechselstroms als Zweigstrom mit einer maximal zulässigen Prüfstromamplitude und einer minimalen Prüfimpulszeit erfolgt in Verbindung mit der Erfassung und Auswertung des zeitlichen Verlaufs von Netzstörungen in einem Differenzstromwandler durch Betrachtung einer Strom-Zeit-Fläche. Da die AC-Messstromwandler in Verbindung mit dem notwendigen Bürdenwiderstand als Hochpass in Erscheinung treten, können langsame Systeme mit einer großen Ableitkapazität und/oder einem großen Isolationswiderstand mit dieser Technik nicht mehr exakt ausgewertet werden, da der Hochpass die Systemantwort nicht mehr passieren lässt.

Eine Isolationsfehlersuche mit adaptiver Anpassung der Prüfpulsperiode in einem Prüfstromgenerator ist in DE 10 2017 209 663 B3 beschrieben. Zur zweigselektiven Bestimmung eines Teilisolationswiderstands in einem zu überwachenden Leitungszweig ist die Information über den Gesamtisolationswiderstand erforderlich. Die Bestimmung eines kapazitiven Elements findet nicht statt.

In der Patentschrift DE 10 2017 217 473 B3 müssen zunächst mittels eines erweiterten Isolationsüberwachungssystems mit Prüfstromgenerator ein Gesamt-Isolationswiderstand und eine Gesamt-Netzableitkapazität des Stromversorgungssystems während des Betriebs kontinuierlich bestimmt werden.

Die Offenlegungsschrift DE 10 2013 218 836 A1zeigt ein Isolationsfehlersuchsystem mit zweigselektiver Einspeisung und ein selektives Isolationsüberwachungssystem für ein verzweigtes, aus mehreren Subsystemen bestehendes IT-System. Zur Isolationsfehlersuche sind in jedem Subsystem eine Differenzstrommesseinrichtung, ein Prüfsignalgenerator und eine Blockierungseinrichtung angeordnet.

Weiter betrifft die Offenlegungsschrift DE 10 2015 216 915 A1 ein Verfahren und ein Isolationsfehlersuchsystem für ein IT-Stromversorgungssystem mit einem Prüfstromgenerator zur Einspeisung eines Prüfstroms, mit einem Prüfstromsensor zur Erfassung eines Prüfstromanteils in einem Abzweig des IT-Stromversorgungssystems und mit einem Auswertegerät zur Auswertung des erfassten Prüfstromanteils.

In den aus dem Stand der Technik bekannten Verfahren und entsprechenden Schaltungsanordnungen zur Isolationsüberwachung einschließlich der Isolationsfehlersuche wird entweder eine Bestimmung kapazitiver Größen nicht durchgeführt, oder, falls neben dem (ohmschen) Isolationswiderstand auch eine kapazitive Größe ermittelt wird, erfordern die Berechnungen die Einbeziehung eines Gesamt-Isolationswiderstands und einer Gesamt-Netzableitkapazität des Stromversorgungssystems.

Zudem setzen die genannten Vorrichtungen neben der zur Isolationswiderstandsmessung erforderlichen Messspannungsquelle einen separaten, konfigurierbaren Prüfstromgenerator zur Isolationsfehlersuche voraus und gestalten sich dadurch schaltungstechnisch recht aufwendig.

Der vorliegenden Erfindung liegt somit die Aufgabe zu Grunde, ein Verfahren sowie eine elektrische Schaltungsanordnung für ein verzweigtes ungeerdetes Stromversorgungssystem vorzuschlagen, die eine zweigselektive Bestimmung resistiver und kapazitiver, isolationsbestimmender Größen des Stromversorgungssystems ermöglichen, wobei der schaltungstechnische und fertigungstechnische Aufwand möglichst gering sein soll.

Diese Aufgabe wird durch ein Verfahren zur zweigselektiven Bestimmung resistiver und kapazitiver, isolationsbestimmender Größen in einem verzweigten ungeerdeten Stromversorgungssystem mit Isolationsüberwachung gemäß Anspruch 1 sowie durch eine dieses Verfahren umsetzende elektrische Schaltungsanordnung nach Anspruch 4 gelöst.

Grundlegende Elemente des beanspruchten Verfahrens und der umsetzenden elektrischen Schaltungsanordnung sind ein in dem verzweigten ungeerdeten Stromversorgungssystem installiertes erfindungsgemäßes Isolationsüberwachungsgerät sowie (jeweils) ein in dem/den zu überwachenden Leitungszweig(en) angeordneter erfindungsgemäßer Sensor.

Das Isolationsüberwachungsgerät wird zwischen mindestens einem aktiven Leiter und Erde angeschlossen und weist einen Messpfad mit einer Messspannungsquelle, mit einem Ankoppelwiderstand und mit einem Messwiderstand mit IMD-Auswerteelektronik auf.

Der (jeweilige) Sensor ist in dem oder den zu überwachenden Leitungszweig(en) des ungeerdeten Stromversorgungssystems angeordnet und weist einen Messstromwandler mit einer Sekundärwicklung zum Messen eines Zweigstroms mittels eines in der Sekundärwicklung sich einstellenden Sekundärstroms auf. Vorzugsweise ist der Messstromwandler allstromsensitiv ausgeführt und damit neben der Erfassung von Wechselströmen auch zur Erfassung von Gleichströmen geeignet. Auch kann, insbesondere aus Kostengründen, ein (reiner) AC-Messstromwandler Verwendung finden, sofern dessen Hochpass-Grenzfrequenz niedriger liegt als die Systemfrequenz.

Die durch den Messstromwandler geführten aktiven Leiter des zu überwachenden Leitungszweiges bilden eine Primärwicklung mit in der Regel (nur) einer Windung aus, durch die ein realer Zweigstrom als Primärstrom fließt.

Nach dem Einschalten einer von der Messspannungsquelle erzeugten Messspannung wird zunächst ein Startsignal über eine Kommunikationsverbindung von dem Isolationsüberwachungsgerät an den Sensor gesendet.

Die Messspannung wird dem Stromversorgungssystem überlagert und besitzt einen periodischen Verlauf, der sich vorzugsweise aus bipolaren, rechteckförmigen Messimpulsen zusammensetzt, weil diese Impulsform einfach zu generieren ist und eine breitbandige Anregung darstellt. Andere Impulsformen wie ein dreieck- oder ein sinusförmiger Verlauf sind ebenfalls möglich.

Eine an dem Messwiderstand infolge des durch die Messspannung getriebenen (Mess-)Stroms abfallende Spannung wird gemessen und als gemessene Spannung aufgezeichnet.

Gleichzeitig erfolgt die Messung eines ebenfalls von der Messspannung getriebenen realen Zweigstroms in dem Sensor mittels des Messstromwandlers mit Ringkern und der Sekundärwicklung über einen in der Sekundärwicklung sich einstellenden realen Sekundärstrom.

Der reale Sekundärstrom wird mittels einer Übertragungsstrecke in dem Sensor in ein zeitdiskretes reales Ausgangssignal transformiert, das in einer CT-Auswerteelektronik des Sensors aufgezeichnet wird.

Nach einer vorbestimmbaren Periodenanzahl der Messspannung erfolgt die Abschaltung der Messspannung.

Ein Messzyklus kann dabei eine oder mehrere Perioden der Messspannung umfassen, wobei im Falle mehrerer Perioden die Perioden der gemessenen Spannungsverläufe übereinandergelegt und mit Blick auf ein Signal-Rauschleistungs-Verhältnis optimiert werden.

In der IMD-Auswerteelektronik wird daraufhin eine Zweigspannung aus der Messspannung, der gemessenen Spannung, dem Ankoppelwiderstand und dem Messwiderstand berechnet und von dem Isolationsüberwachungsgerät an den Sensor des zu überwachenden Leitungszweiges mittels der Kommunikationsverbindung übermittelt. Im (Regel-)Fall mehrerer zu überwachender Leitungszweige mit jeweils einem installierten Sensor erhalten zeitgleich alle betreffenden Sensoren den gleichen Verlauf der Zweigspannung ("Broadcasting").

In der CT-Auswerteelektronik erfolgt nun die Berechnung eines nachgebildeten Zweigstroms aus der Zweigspannung, der zeitlichen Ableitung der Zweigspannung, einem geschätzten Isolationswiderstand des zu überwachenden Leitungszweiges und einer geschätzten Ableitkapazität des zu überwachenden Leitungszweiges. Grundlage der Berechnungen bilden neben den für lineare Netzwerke gültigen Gesetzmäßigkeiten (Knotenpunktsregel, Maschenregel), insbesondere die für kapazitive Elemente geltenden Strom-Spannungsbeziehungen.

Als Startwerte für den Isolationswiderstand und für die Ableitkapazität, die in die Berechnung des nachgebildeten Zweigstroms eingehen, werden Schätzwerte verwendet, die auf dem Erfahrungswissen mit vergleichbaren Stromversorgungssystemen beruhen. Die Startwerte können im Hinblick auf eine schnelle Näherungslösung aus der laufenden Messung eines Gesamt-Isolationswiderstands oder einer Gesamt-Ableitkapazität eingegrenzt werden, sofern das Isolationsüberwachungsgerät diese Werte über die Kommunikationsverbindung bereitstellen kann.

Der berechnete nachgebildete Zweigstrom wird durch den Sensor mittels des Messstromwandlers über eine Hilfswicklung und eine von einem Digital-Analog-Umsetzer (DA-Umsetzer) gesteuerte Stromquelle in Funktion eines weiteren Primärstroms - neben dem durch die aktiven Leiter fließenden realen Zweigstrom - eingespeist. Der Messstromwandler umfasst somit neben dem Ringkern und der Sekundärwicklung als weiteres erfindungswesentliches Element eine zusätzliche Wicklung, nämlich die Hilfswicklung zum Einspeisen des nachgebildeten Zweigstroms.

Dabei muss die Hilfswicklung nicht integraler körperlicher Bestandteil des Messstromwandlers sein, sondern es kann eine von dem Messstromwandler separierbare Wicklung, beispielsweise in Form einer durch den Ringkern geführten Leiterschleife, verwendet werden. Dies hat den Vorteil, dass installierte übliche, dem Stand der Technik entsprechende Messstromwandler in dem Stromversorgungssystem verbleiben können und in einfacher Weise nachgerüstet werden können.

Der über die Hilfswicklung eingespeiste nachgebildete Zweigstrom wird mittels eines in der Sekundärwicklung des Messstromwandlers sich einstellenden nachgebildeten Sekundärstroms gemessen, mittels der Übertragungsstrecke in ein zeitdiskretes nachgebildetes Ausgangssignal transformiert und in der CT-Auswerteelektronik aufgezeichnet.

Damit durchlaufen der reale Zweigstrom und der nachgebildete Zweigstrom von der Erfassung in dem Ringkern bis zu der Aufzeichnung des zeitdiskreten realen Ausgangssignals und des zeitdiskreten nachgebildeten Ausgangssignals in der CT-Auswerteelektronik den gleichen Übertragungsweg. Dieser setzt sich aus der Messung in dem Messstromwandler mit Ringkern und Sekundärwicklung und der Transformation in der Übertragungsstrecke zusammen und kann als wesentliches Element der Erfindung als Black Box aufgefasst werden.

Hieraus ergibt sich der Vorteil, dass die genauen, oft schwierig zu ermittelnden und sich in Abhängigkeit der Zeit, der Temperatur oder durch Umgebungsbedingungen und Störeinflüsse sich ändernde Übertragungeigenschaften dieser Black Box nicht bekannt sein müssen. Das Verfahren wird dadurch signifikant vereinfacht, denn die zeitdiskreten Ausgangssignale können direkt miteinander verglichen und bewertet werden.

Nach Abschalten der Einspeisung des nachgebildeten Zweigstroms erfolgt die Auswertung der zeitdiskreten Ausgangssignale in der CT-Auswerteelektronik in Form der Berechnung der Fehlerquadratsumme zwischen dem realen Ausgangssignal und dem nachgebildeten Ausgangssignal.

Falls die Fehlerquadratsumme hinreichend klein ist, also einen vorgebbaren Grenzwert unterschreitet, wird der Isolationswiderstand und die Ableitkapazität als Berechnungsergebnis an das Isolationsüberwachungsgerät über die Kommunikationsverbindung übermittelt und kann angezeigt oder weiterverarbeitet werden.

Fortlaufend erfolgt ein Neuberechnen von Schätzwerten für den Isolationswiderstand und die Ableitkapazität in der CT-Auswerteelektronik.

Dabei wird in jedem Messzyklus mit der Neuberechnung der Schätzwerte für den Isolationswiderstand und für die Ableitkapazität ein Iterationsschritt ausgeführt mit dem Ziel, die Fehlerquadratsumme zu minimieren und somit die Schätzung des Isolationswiderstands und der Ableitkapazität den tatsächlichen Werten anzunähern.

Mit dem Einschalten der Messspannung kann anschließend ein neuer Messzyklus mit dem neuberechneten Isolationswiderstand und der neuberechneten Ableitkapazität gestartet werden.

Das erfindungsgemäße Verfahren erlaubt somit in vorteilhafter Weise die zweigselektive Messung des Isolationswiderstands und der Ableitkapazität bei Nutzung und erfindungsgemäßer Modifikation aus der Isolationswiderstandsmessung und Isolationsfehlersuche bekannter und bewährter Systembestandteile (Isolationsüberwachungsgerät und Sensor) und bei gleichzeitigem Verzicht auf einen separaten Prüfstrom-Generator, da zur Erzeugung des Prüfstroms der in dem normgemäß vorgeschriebenen Isolationsüberwachungsgerät von der Messspannung getriebene Messstrom als realer Zweigstrom zur Fehlersuche herangezogen wird.

In weiterer vorteilhafter Ausgestaltung erfolgt das Transformieren sowohl des realen als auch des nachgebildeten Sekundärstroms auf der Übertragungsstrecke durch Spannungsabgreifen des jeweiligen Sekundärstroms an einem Bürdenwiderstand, Tiefpassfiltern mittels eines Tiefpassfilters mit Wirkung einer groben Netzfrequenzfilterung, variables Verstärken durch einen Verstärker mit variabler Verstärkung und Analog-Digitales Umsetzen in einem Analog-Digital-Umsetzer (AD-Umsetzer).

Aufgrund der Betrachtung als Black Box gibt es nur zwei einzuhaltende Randbedingungen, welche die Eigenschaften der Übertragungsstrecke in der Black Box betreffen. Die Aussteuerung des AD-Umsetzers muss optimal sein und die Unterscheidbarkeit zwischen überlagertem Messsignal und systembedingten Eingangssignal muss gegeben sein. Erstgenannter Punkt lässt sich mit der Dimension der Bürde und der Einstellung des variablen Verstärkers erreichen. Letztgenannter Punkt ist vor allem durch die Grenzfrequenz des Hochpasses aus Sekundärwicklung und Bürdenwiderstand und der Grenzfrequenz des Tiefpasses beeinflussbar und hängt direkt mit der Einschwingzeit des zu überwachenden Stromversorgungssystems zusammen.

Mit der Anordnung der Hilfswicklung als weitere Wicklung an dem zum Sensor gehörenden Messstromwandler in Verbindung mit der iterativen Nachbildung des realen Stromverlaufs erfolgt die damit einhergehende Ermittlung der Leitungszweig-Größen Isolationswiderstand und Ableitkapazität in erfindungsgemäßer, vorteilhafter Weise.

Durch diese Herangehensweise, mit der bewusst auf eine komplexe (mathematische) Beschreibung der Übertragungsstrecke der Strommessung verzichtet wird, können weniger hochwertige Standard-Systembestandteile (Verstärker, magnetische Kernmaterialien) verwendet werden. Linearitäten, Temperaturstabilität und Sättigungsverhalten spielen in dem erfindungsgemäßen Messverfahren und an dieser Stelle der Messkette nur eine untergeordnete Rolle, sodass entsprechend der Aufgabenstellung eine kostengünstige Lösung erreichbar ist.

Als weitere Vorteile ergeben sich, dass keine Kalibrierung des Messsystems erforderlich ist und dass das Verfahren mit deutlich kleineren Pegeln des Messstroms arbeitet, wodurch die Störung anderer sensibler Systembestandteile durch zu große Gleichtaktströme vermieden werden kann, sowie, dass für den Durchlauf der Rechteck-Anregeperioden und der damit verbundenen Auswertung keine eingeschwungenen Systemzustände abgewartet werden müssen und daher insbesondere die Identifikation eines fehlerbehafteten Leitungszweiges mit der normativen Forderung nach einer schnellen Beseitigung des Isolationsfehlers erfüllt wird.

Vorteilhaft ist weiterhin, dass das Isolationsüberwachungsgerät bei laufender Bestimmung des fehlerbehafteten Leitungszweigs die Gesamt-Isolationsimpedanz des Stromnetzes messen kann. Dies ist bei klassischen Isolationsfehlersuchsystemen mit einem Prüfstromgenerator häufig nicht der Fall.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** das Funktionsprinzip einer Isolationsfehlersuche nach dem Stand der Technik,

**Fig. 2:** ein Ersatzschaltbild eines verzweigten ungeerdeten Stromversorgungssystems mit Isolationsüberwachungsgerät,

**Fig. 3:** schematisch eine Struktur der erfindungsgemäßen elektrischen Schaltungsanordnung,

**Fig. 4:** ein Blockschaltbild eines erfindungsgemäßen Sensors,

**Fig. 5:** ein Ablaufdiagramm des erfindungsgemäßen Verfahrens und

**Fig. 6:** Zeitsignale und deren Auswertung.

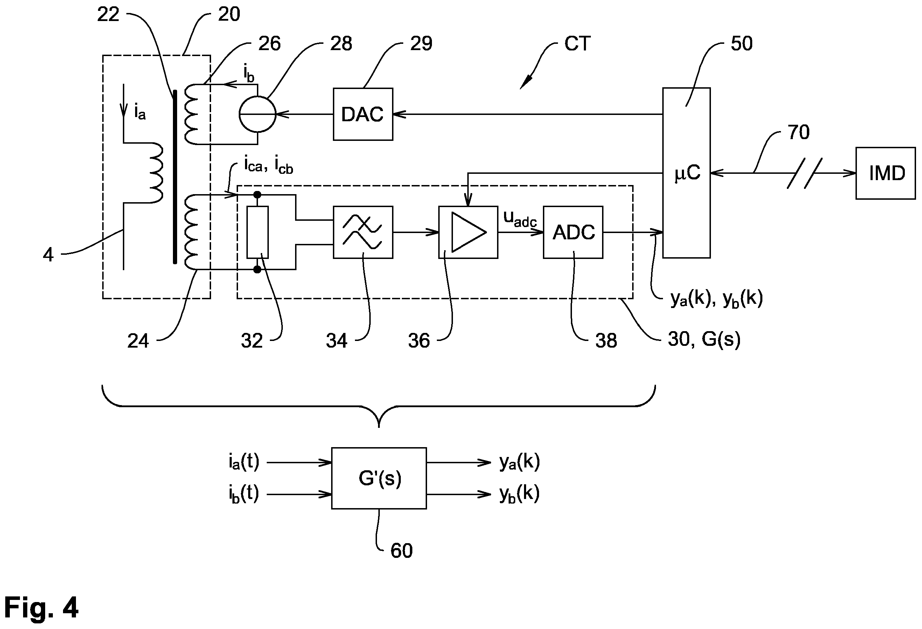

**Fig. 1** zeigt beispielhaft an einer Isolationsfehler-Sucheinrichtung 12 der Fa. Bender GmbH & Co. KG [EDS309x_D00012_xx_M_XXDE.pdf (www.bender.de), Seite 21, Abb. 4.1] das Funktionsprinzip einer Isolationsfehlersuche nach dem Stand der Technik für ein verzweigtes, ungeerdetes Stromversorgungssystem 2 mit einem Hauptsystem 3 und einem (Leitungs-)Zweig 4.

Die Isolationsfehler-Sucheinrichtung 12 umfasst einen Prüfstrom-Generator 14, einen dem Stand der Technik entsprechenden Sensor ZCT und ein Isolationsfehlersuchgerät 16.

Der Prüfstrom-Generator 14 speist in das Stromversorgungssystem 2 einen netzgetriebenen Prüfstrom $I_L$ ein, der als realer Zweigstrom $i_{ca}$ in dem mit dem Isolationsfehler $R_{fN}$ behafteten Leitungszweig 4 von einem Sensor ZCT gemessen wird. Der Sensor ZCT ist gemäß dem Stand der Technik als Ringkern-Messstromwandler 20 mit einem Ringkern 22 und einer Sekundärwicklung 24 ausgeführt, die mit dem Isolationsfehlersuchgerät 16 verbunden ist.

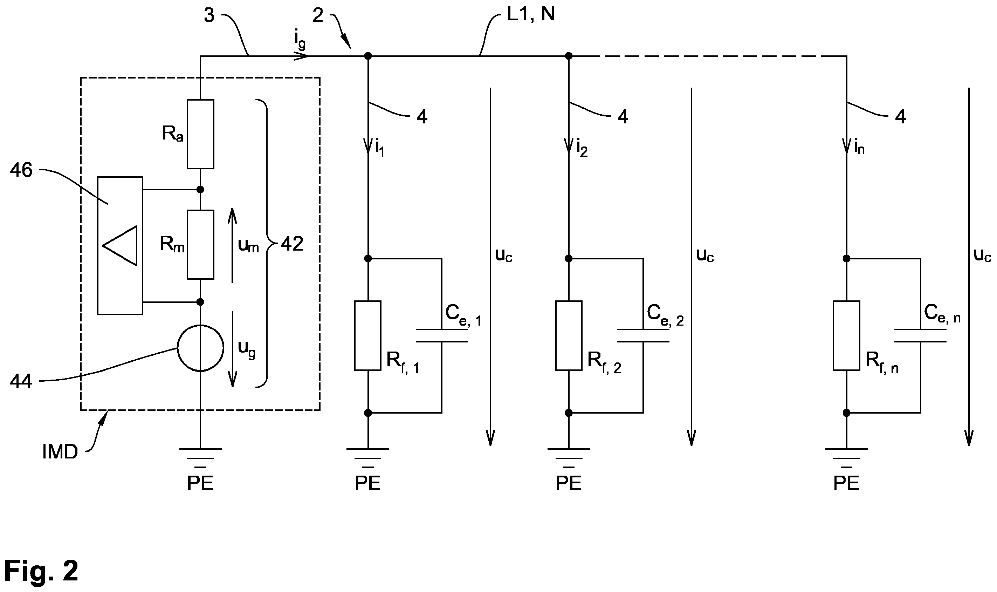

In **Fig. 2** ist ein Ersatzschaltbild des verzweigten ungeerdeten Stromversorgungssystems 2 mit einem Isolationsüberwachungsgerät IMD angegeben.

Das Isolationsüberwachungsgerät IMD wird durch einen Messpfad 42 dargestellt, der zwischen einem aktiven Leiter L1, N und Erde PE verläuft und einen Ankoppelwiderstand $R_a$, eine Messspannungsquelle 44 zum Einspeisen einer Messspannung $u_g$ als (Mess-)Systemanregung und einen Messwiderstand $R_m$ mit IMD-Auswerteelektronik 46 zum Abgriff und Auswertung der gemessenen Spannung $u_m$ umfasst.

Für das (Messsignal-)Verhalten wird davon ausgegangen, dass die in Bezug zu der Messspannung $u_g$, deren Frequenz wenige Hz beträgt oder im Sub-Hertz Bereich liegt, die höherfrequente Netzspannung (50/60 Hz oder höher) durch geeignete Filter von dem Messsystem entkoppelt ist.

Die Messspannung $u_g$ ist vorgegeben und die gemessene Spannung $u_m$ ist durch Messung bekannt. Weiterhin sind der Messwiderstand $R_m$ sowie der Ankoppelwiderstand $R_a$ bekannt.

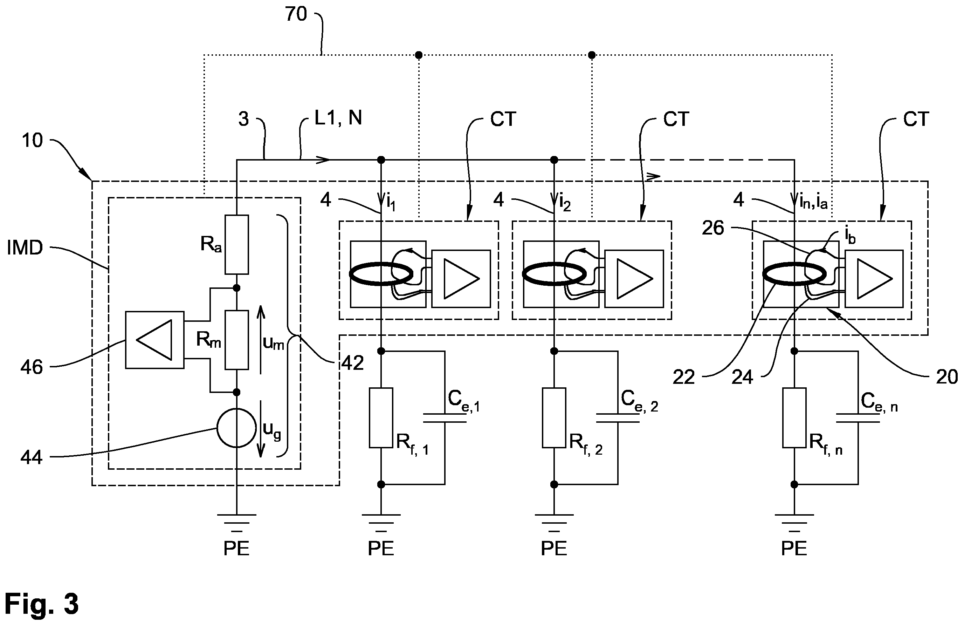

Berechnet werden soll der jeweilige Zweigstrom $i_1$, $i_2$,..., $i_n$ für die angenommene Kombination aus den isolationsbestimmenden Größen Isolationwiderstand $R_{f,n}$ und Ableitkapazität $C_{e,n}$. Der jeweilige Zweigstrom $i_1$, $i_2$,..., $i_n$ entspricht dabei dem in dem ausgewählten, zu überwachenden Leitungszweig fließenden realen Zweigstrom $i_a$ (Fig. 3).

Zunächst wird gemäß Gl. 1.1 die Zweigspannung $u_c$ berechnet. Ausgehend von vernachlässigbar kleinen Kabelimpedanzen ist diese an allen Leitungszweigen 1, 2, ..., n identisch.

$$u_c = u_g - u_m \left(1 + \frac{R_a}{R_m}\right) \qquad\qquad \text{Gl 1.1}$$

Der Gesamtstrom $i_g$ entspricht dem von der Messspannung $u_g$ getriebenen (Mess-)Strom und entspricht der Summe der Zweigströme $i_1$, $i_2$,..., $i_n$ gemäß Gl.1.2.

$$i_g = i_1 + i_2 + ... + i_n \qquad\qquad \text{Gl. 1.2}$$

Im Zeitbereich berechnet sich der jeweilige Zweigstrom (hier beispielhaft der Zweigstrom $i_n$) aus der Zweigspannung $u_c$ mit den angenommenen Größen $R_{f,n}$ und $C_{e,n}$ gemäß Gl. 1.3.

$$i_n = \frac{u_c}{R_{f,n}} + C_{e,n} \cdot \frac{du_c}{dt} \qquad\qquad \text{Gl. 1.3}$$

Überführt man Gl. 1.3 in den zeitdiskreten Bereich, so gelangt man zu Gl. 1.4, wobei $f_s$ die Abtastfrequenz und k der Abtastwerte-Index sind.

$$i_n(k) = \frac{u_c(k)}{R_{f,n}} + f_s \cdot C_{e,n} \cdot (u_c(k) - u_c(k-1)) \qquad\qquad \text{Gl. 1.4}$$

Fig. 3 zeigt schematisch eine Struktur der erfindungsgemäßen elektrischen Schaltungsanordnung 10, bestehend aus dem Isolationsüberwachungsgerät IMD und den erfindungsgemäßen Sensoren CT.

Das Isolationsüberwachungsgerät IMD umfasst (vgl. Fig. 2) den zwischen dem aktiven Leiter L1, N und Erde PE geschalteten Messpfad 42 mit dem Ankoppelwiderstand $R_a$, der Messspannungsquelle 44 und dem Messwiderstand $R_m$ mit IMD-Auswerteelektronik 46.

In den Leitungszweigen 4 messen die Sensoren CT die jeweiligen tatsächlichen Zweigströme $i_1$, $i_2$,..., $i_n$, wobei der jeweils betrachtete Zweigstrom $i_1$, $i_2$,..., $i_n$ - in Fig. 3 beispielhaft der Zweigstrom $i_n$ - als tatsächlich gemessener, realer Zweigstrom $i_a$ bezeichnet wird.

Zwischen dem Isolationsüberwachungsgerät IMD und den Sensoren CT, verläuft eine, vorzugsweise bidirektionale, Kommunikationsverbindung 70, die beispielsweise als RS485-Schnittstelle ausgeführt sein kann. Die Anforderungen an die Kommunikationsverbindung 70 sind, dass Trigger-Signale für den Abgleich der Messsysteme in Echtzeit (Latenz < 10ms) übertragen werden können.

Zusätzlich und alternierend zur Einspeisung und Messung des realen Zweigstroms $i_a$ dient die oben beschriebene Berechnung des Zweigstroms $i_n$ auf Basis der geschätzten Größen Isolationswiderstand $R_f$ und Ableitkapazität $C_e$ nach den Gl. 1.3 und 1.4 dazu, einen entsprechenden Stromfluss als nachgebildeten Zweigstrom $i_b$ durch den betreffenden Sensor CT zu leiten und zu messen.

Dazu wird der Messstromwandler 20 des aus dem Stand der Technik bekannten Sensors ZCT aus Fig.1 um eine Hilfswicklung 26 mit (nur) einer Windung erweitert. Die Hilfswicklung 26 ist hier beispielhaft als Leiterschleife ausgeführt und kann als separater Bestandteil einen bereits installierten, aus dem Stand der Technik bekannten Sensor ZCT ergänzen. Alternativ kann die Hilfswicklung 26 auch integraler körperlicher Bestandteils des Messstromwandlers 20 sein.

Der berechnete und mit einer Stromquelle 28 (Fig. 4) in die Hilfswicklung 26 eingespeiste nachgebildete Zweigstrom $i_b$ entspricht bei hinreichend genau berechneter Kombination aus Isolationswiderstand $R_f$ und Ableitkapazität $C_e$ dem Stromverlauf des realen Zweigstroms $i_n = i_a$.

Beide Stromverläufe, der des realen Zweigstroms $i_a$ und der des nachgebildeten Zweigstroms $i_b$, werden nacheinander über die Sekundärwicklung 24 des Messstromwandlers 20 des Sensors CT als realer Sekundärstrom $i_{ca}$ und als nachgebildeter Sekundärstrom $i_{cb}$ erfasst und miteinander verglichen.

**Fig. 4** zeigt ein Blockschaltbild des erfindungsgemäßen Sensors CT.

Der Sensor CT umfasst als aus dem Stand der Technik bekannte Elemente einen AC-Messstromwandler 20 mit dem Ringkern 22 und Sekundärwicklung 24. Die Sekundärwicklung 24 ist vorzugsweise mit einer Windungszahl im hunderter Bereich, z.B. 600, ausgeführt.

Als Primärwicklung wird der den realen Zweigstrom $i_a$ führende Leitungszweig 4 - in der Regel einmal - durch den Ringkern 22 geführt.

Zusätzlich zu dem aus dem Stand der Technik bekannten Sensor ZCT aus Fig. 1 weist der Messstromwandler 20 des erfindungsgemäßen Sensors CT in Fig. 4 die Hilfswicklung 26 auf.

Die Hilfswicklung 26 des Messstromwandlers 20 stellt ein wesentliches, neues Element dar, über die der nachgebildete Zweigstrom $i_b$ eingespeist wird. Die Hilfswicklung 26 wird von der Stromquelle 28 gespeist, welche ihrerseits von einem Digital-Analog-Umsetzer 29 als μC-Peripherie gesteuert wird. Alternativ ist eine Ansteuerung mittels Pulsweiten-Modulation (PWM) mit anschließender Tiefpassfilterung möglich.

Der Sensor CT weist weiterhin eine CT-Auswerteelektronik 50 auf, die einen Mikroprozessor zur Ausführung der Berechnungen umfasst.

Weiterhin umfasst der Sensor CT erfindungsgemäß eine Übertragungsstrecke 30, die einen Bürdenwiderstand 32, ein Tiefpassfilter 34, einen Verstärker mit variabler Verstärkung 36 und einen Analog-Digital-Umsetzer 38 aufweist. Die Übertragungsstrecke 30 mit der Übertragungsfunktion G(s) transformiert den zeitkontinuierlichen realen Sekundärstrom $i_{ca} = i_{ca}(t)$ und den zeitkontinuierlichen nachgebildeten Sekundärstrom $i_{cb} = i_{cb}(t)$ in das entsprechende zeitdiskrete reale Ausgangssignal $y_a(k)$ und das nachgebildete Ausgangssignal $y_b(k)$.

Das Übertragungssystem, bestehend aus dem Messstromwandler 20 und der Übertragungsstrecke 30 - mit dem realen/nachgebildeten Zweigstrom $i_a(t)/i_b(t)$ als sukzessives anliegendes Eingangssignal bis zu dem entsprechenden realen/nachgebildeten Ausgangssignal $y_a(k)/y_b(k)$ - wird als Black Box 60 mit der Übertragungsfunktion G'(s) angenommen.

Die Übertragungsfunktion G'(s) dieses gesamten Übertragungssystems (Messstromwandler 20 und Übertragungsstrecke 30) muss nicht bekannt sein, sodass sich im Sinne der Aufgabenstellung die Problemlösung erheblich vereinfacht. Rechnerisch spielen die Eigenschaften der Black-Box 60 keine Rolle. Relevant ist nur, dass während eines Messzyklus, also der sequentiellen Erfassung der Zweigströme $i_a(t)$ und $i_b(t)$ mit einer Zeitdauer < 1 min keine messbare Änderung der Eigenschaften des Übertragungssystems erfolgt.

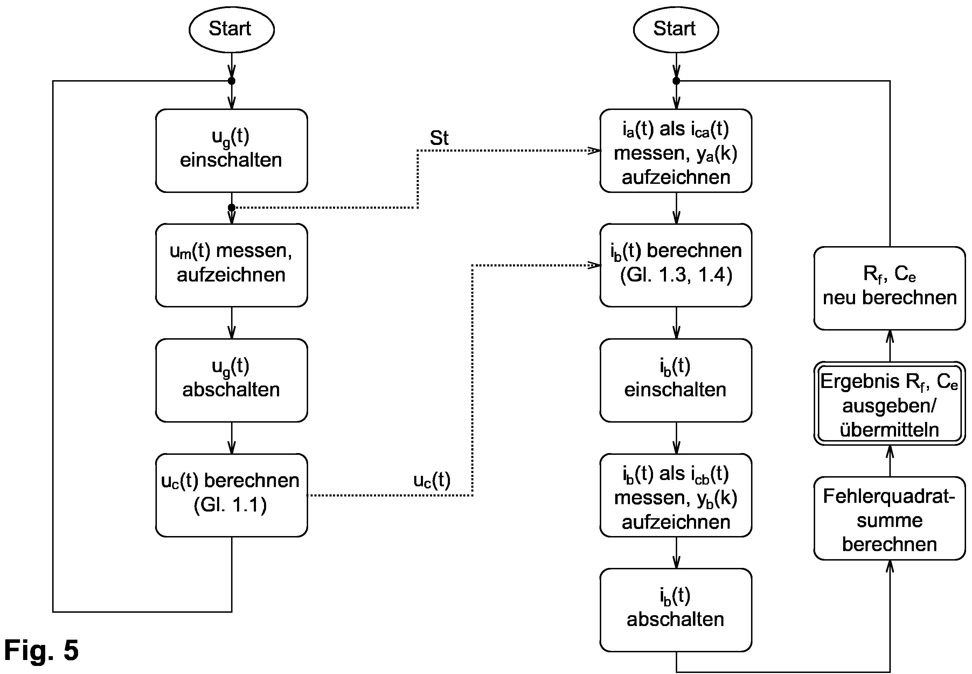

In **Fig. 5** ist ein Ablaufdiagramm des erfindungsgemäßen Verfahrens dargestellt. Die linke Seite spiegelt dabei den Ablauf der Verfahrensschritte in dem Isolationsüberwachungsgerät IMD wider während auf der rechten Seite der Ablauf in dem Sensor CT dargestellt ist.

Das Isolationsüberwachungsgerät IMD übernimmt die Rolle als Master, während die Sensoren CT als Slave auftreten. Das Isolationsüberwachungsgerät IMD startet mit dem Einschalten (Aktivieren) der Messspannung $u_g(t)$ die vorzugsweise durch eine bipolare periodische Rechteckfunktion gebildet wird. Unmittelbar damit verbunden wird ein Startsignal St als Auslöseimpuls an die Sensoren CT verteilt. Während die Sensoren CT daraufhin den jeweiligen realen Zweigstrom $i_a(t)$ in Form eines realen Sekundärstroms $i_{ca}(t)$ messen und in ein reales Ausgangssignal $y_a(k)$ transformieren und aufzeichnen, zeichnet das Isolationsüberwachungsgerät IMD die gemessene Spannung $u_m(t)$ (nach AD-Umsetzung) zeitdiskret auf.

Nach einer festgelegten, vorbestimmbaren Periodenanzahl (Messzyklus) wird die Messspannung $u_g(t)$ abgeschaltet (deaktiviert) und sowohl die Aufzeichnung der gemessenen Spannung $u_m(t)$ im Isolationsüberwachungsgerät IMD als auch des realen Ausgangssignals $y_a(k)$ im Sensor CT gestoppt.

Umfasst der Messzyklus mehrere Perioden, so werden die Messverläufe der gemessenen Spannung $u_m(t)$ und des realen Ausgangssignals $y_a(k)$ durch digitale signalverarbeitende Filteralgorithmen wie beispielsweise eine Mittelwertbildung hinsichtlich des Signal-Rauschleistungs-Verhältnisses optimiert.

Es folgt die Berechnung der Zweigspannung $u_c(t)$ im Isolationsüberwachungsgerät IMD, welche sodann, vorzugsweise als Array mit fester Dimension, an die Sensoren CT übermittelt wird.

In der CT-Auswerteelektronik 50 der Sensoren CT wird daraufhin mit den geschätzten Größen Isolationswiderstand $R_f$ und Ableitkapazität $C_e$ sowie der Zweigspannung $u_c(t)$ der nachgebildete Zweigstrom $i_b(t)$ berechnet und mittels des Digital-Analog-Umsetzers 29 und der Stromquelle 28 auf die Hilfswicklung 26 eingeprägt.

Währenddessen erfolgt die Messwertaufnahme des nachgebildeten Zweigstroms $i_b(t)$ als nachgebildeter Sekundärstrom $i_{cb}(t)$und dessen Transformation mittels der Übertragungsstrecke 30 in das nachgebildete Ausgangssignal $y_b(k)$. Auch dieser Signalverlauf wird mittels digitaler Signalverarbeitung optimiert.

Es folgt eine Berechnung der Fehlerquadratsumme gemäß

$$\sum_{k=0}^{n}(y_b(k) - y_a(k))^2 \;\to Min \qquad\qquad (Gl.\ 2)$$

zwischen dem realen Ausgangssignal $y_a(k)$ und dem nachgebildeten Ausgangssignal $y_b(k)$) und eine Optimierung der Simulationsgrößen Isolationswiderstand $R_f$ und Ableitkapazität $C_e$ in der CT-Auswerteelektronik 50 mittels eines iterativen Näherungsverfahrens, bevor der Messzyklus von neuem startet.

Nur dann, wenn die Fehlerquadratsumme einen hinreichend minimalen Wert erreicht, wird in dem aktuell ablaufenden Messzyklus das entsprechende Größenpaar Isolationswiderstand $R_f$ und Ableitkapazität $C_e$ als Ergebniswert ausgegeben und an das Isolationsüberwachungsgerät IMD übermittelt.

In einem weiteren Schritt erfolgt eine Neuberechnung von Schätzwerten des Isolationswiderstands und der Ableitkapazität, um in der sich kontinuierlich fortsetzenden Abfolge von Messzyklen innerhalb des folgenden Messzyklus mit dem darin auszuführenden Iterationsschritt die Fehlerquadratsumme durch zielgerichtete Änderung der Schätzwerte weiter zu minimieren.

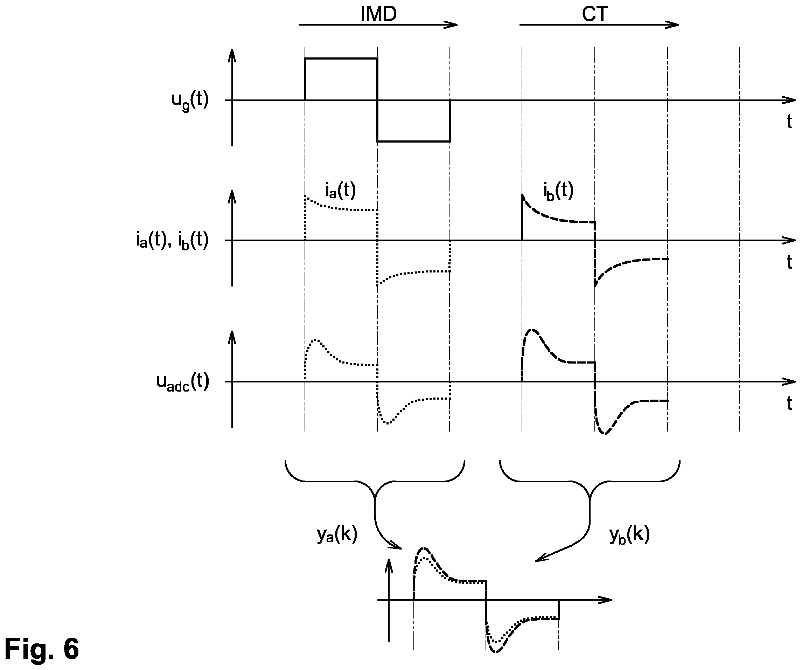

Verdeutlicht wird das Verfahren durch die in **Fig.6** dargestellten Zeitsignale und deren Auswertung.

Dargestellt ist das zeitbegrenzte Aufschalten der bipolaren, rechteckförmigen Messspannung $u_g(t)$, die sequentielle Einspeisung des realen Zweigstroms $i_a(t)$ und des nachgebildeten Zweigstroms $i_b(t)$, eine entsprechende Eingangsspannung $u_{adc}(t)$ des Analog-Digital-Umsetzers 38 mit ersichtlicher Verformung durch das Übertragungssystem (Black Box 60) sowie die aus der Erfassung der Zweigströme $i_a(t)$, $i_b(t)$ abgeleiteten Ausgangssignale $y_a(k)$, $y_b(k)$ - vereinfachend als kontinuierlicher Zeitverlauf dargestellt - der Übertragungsstrecke 30 im Vergleich.

Der Vergleich des realen Ausgangssignals $y_a(k)$ mit dem nachgebildeten Ausgangssignal $y_b(k)$ zeigt, dass durch Minimierung der Fehlerquadratsumme eine weitgehende Übereinstimmung zwischen beiden Ausgangssignalen $y_a(k)$, $y_b(k)$ erzielt werden kann. Hieraus folgt, dass auch die auf diese Weise iterativ ermittelten Größen Isolationswiderstand $R_f$ und Ableitkapazität $C_e$ den tatsächlich in dem ungeerdeten Stromversorgungssystem vorherrschenden Werten entsprechen.

**Patentansprüche**

1. Verfahren zur zweigselektiven Bestimmung resistiver und kapazitiver, isolationsbestimmender Größen ($R_f$, $C_e$) in einem verzweigten ungeerdeten Stromversorgungssystem (2) mit Isolationsüberwachung, umfassend die Verfahrensschritte:

   Einschalten einer periodischen Messspannung ($u_g(t)$) mittels eines Isolationsüberwachungsgerätes (IMD), welches zwischen mindestens einen aktiven Leiter (L1) und Erde (PE) angeschlossen wird und einen Messpfad (42) mit einer Messspannungsquelle (44), mit einem Ankoppelwiderstand ($R_a$) und mit einem Messwiderstand ($R_m$) mit IMD-Auswerteelektronik (46) aufweist,
   Senden eines Startsignals (St) über eine Kommunikationsverbindung (70) von dem Isolationsüberwachungsgerät (IMD) an einen Sensor (CT), welcher in einem zu überwachenden Leitungszweig (4) des ungeerdeten Stromversorgungssystems (2) angeordnet ist,
   Messen und Aufzeichnen einer an dem Messwiderstand ($R_m$) abfallenden gemessenen Spannung ($u_m(t)$),
   Messen eines von der Messspannung ($u_g(t)$) getriebenen realen Zweigstroms ($i_a(t)$) in dem Sensor (CT) mittels eines Messstromwandlers (20) mit einem Ringkern (22) und einer Sekundärwicklung (24) über einen in der Sekundärwicklung (24) sich einstellenden realen Sekundärstrom ($i_{ca}(t)$),
   Transformieren des realen Sekundärstroms ($i_{ca}(t)$) in ein zeitdiskretes reales Ausgangssignal ($y_a(k)$) mittels einer Übertragungsstrecke (30) in dem Sensor (CT),
   Aufzeichnen des realen Ausgangssignals ($y_a(k)$) in einer CT-Auswerteelektronik (50) des Sensors (CT),
   Abschalten der Messspannung ($u_g(t)$) in dem Isolationsüberwachungsgerät (IMD) nach einer vorbestimmbaren Periodenanzahl, Berechnen einer Zweigspannung ($u_c(t)$) aus der Messspannung ($u_g(t)$), der gemessenen Spannung ($u_m(t)$), dem Ankoppelwiderstand ($R_a$) und dem Messwiderstand ($R_m$) in der IMD-Auswerteelektronik (46), Übermitteln der Zweigspannung ($u_c(t)$) von dem Isolationsüberwachungsgerät (IMD) an den Sensor (CT) des zu überwachenden Leitungszweiges (4) mittels der Kommunikationsverbindung (70), Berechnen eines nachgebildeten Zweigstroms ($i_b(t)$) aus der Zweigspannung ($u_c(t)$), der zeitlichen Ableitung ($d(u_c(t))/dt$) der Zweigspannung ($u_c(t)$), einem Isolationswiderstand ($R_f$) des zu überwachenden Leitungszweiges (4) und einer Ableitkapazität ($C_e$) des zu überwachenden Leitungszweiges (4) in der CT-Auswerteelektronik (50), wobei für den Isolationswiderstand ($R_f$) und die Ableitkapazität ($C_e$) jeweils ein Schätzwert als Startwert verwendet wird, Einspeisen des nachgebildeten Zweigstroms ($i_b(t)$) durch den Sensor (CT) mittels des Messstromwandlers (20) über eine Hilfswicklung (26) und eine von einem DA-Umsetzer (29) gesteuerte Stromquelle (28), Messen des nachgebildeten Zweigstroms ($i_b(t)$) mittels eines in der Sekundärwicklung (24) des Messstromwandlers (20) sich einstellenden nachgebildeten Sekundärstroms ($i_{cb}(t)$), Transformieren des nachgebildeten Sekundärstroms ($i_{cb}(t)$) in ein zeitdiskretes nachgebildetes Ausgangssignal ($y_b(k)$) mittels der Übertragungsstrecke (30) und Aufzeichnen des nachgebildeten Ausgangssignals ($y_b(k)$) in der CT-Auswerteelektronik (50), Abschalten der Einspeisung des nachgebildeten Zweigstroms ($i_b(t)$), Berechnen der Fehlerquadratsumme zwischen dem realen Ausgangssignal ($y_a(k)$) und dem nachgebildeten Ausgangssignal ($y_b(k)$) in der CT-Auswerteelektronik (50) Übermitteln des Isolationswiderstands ($R_f$) und der Ableitkapazität ($C_e$) als Berechnungsergebnis an das Isolationsüberwachungsgerät (IMD) über die Kommunikationsverbindung (70), falls die Fehlerquadratsumme hinreichend klein ist, Neuberechnen von Schätzwerten für den Isolationswiderstand ($R_f$) und für die Ableitkapazität ($C_e$) in der CT-Auswerteelektronik (50), Starten eines neuen Messzyklus mit dem Einschalten der Messspannung ($u_g(t)$) und mit dem neuberechneten Isolationswiderstand ($R_f$) und der neuberechneten Ableitkapazität ($C_e$).

2. Verfahren nach Anspruch 1,
   **dadurch gekennzeichnet,**
   **dass** das Transformieren auf der Übertragungsstrecke (30) durch Spannungsabgreifen des jeweiligen Sekundärstroms ($i_{ca}(t)$, $i_{cb}(t)$) an einem Bürdenwiderstand (32), Tiefpassfiltern (34), variables Verstärken (36) und Analog-Digitales Umsetzen (38) erfolgt.

3. Verfahren nach Anspruch 1 oder 2,
   **dadurch gekennzeichnet,**
   **dass** zum Messen des Zweigstroms ($i_a(t)$, $i_b(t)$) ein allstromsensitiver Messstromwandler (20) verwendet wird.

4. Verfahren nach einem der Ansprüche 1 bis 3,
   **dadurch gekennzeichnet,**
   **dass** die periodische Messspannung ($ug(t)$) aus bipolaren rechteckförmigen Messimpulsen gebildet wird.

5. Verfahren nach einem der Ansprüche 1 bis 4,
   **dadurch gekennzeichnet,**
   **dass** als Hilfswicklung (26) des Messstromwandlers (20) eine von dem Messstromwandler (20) separierbare Wicklung verwendet wird.

6. Elektrische Schaltungsanordnung (10) zur zweigselektiven Bestimmung resistiver und kapazitiver, isolationsbestimmender Größen ($R_f$, $C_e$) in einem verzweigten ungeerdeten Stromversorgungssystem (2) mit Isolationsüberwachung,

   bestehend aus
   einem Isolationsüberwachungsgerät (IMD), welches zwischen mindestens einem aktiven Leiter (L1) und Erde (PE) angeschlossen ist und einen Messpfad (42) mit einer Messspannungsquelle (44), mit einem Ankoppelwiderstand ($R_a$) und mit einem Messwiderstand ($R_m$) mit IMD-Auswerteelektronik (46) aufweist und aus einem Sensor (CT), welcher in einem zu überwachenden Leitungszweig (4) des ungeerdeten Stromversorgungssystems (2) angeordnet ist und einen Messstromwandler (20) mit einem Ringkern (22) und einer Sekundärwicklung (24) aufweist zum Messen eines Zweigstroms ($i_a(t)$, $i_b(t)$) mittels eines in der Sekundärwicklung (24) sich einstellenden Sekundärstroms ($i_{ca}(t)$, $i_{cb}(t)$), wobei das Isolationsüberwachungsgerät (IMD) ausgelegt ist zum Einschalten einer von der Messspanungsquelle (44) erzeugten periodischen Messspannung ($u_g(t)$) und Abschalten der Messspannung ($u_g(t)$) nach einer vorbestimmbaren Periodenanzahl sowie zum Messen und Aufzeichnen einer an dem Messwiderstand ($R_m$) abfallenden gemessenen Spannung ($u_m(t)$),
   **dadurch gekennzeichnet,**
   **dass** die IMD-Auswerteelektronik (46) ausgelegt ist zur Berechnung einer Zweigspannung ($u_c(t)$) aus der Messspannung ($ug(t)$), der gemessenen Spannung ($u_m(t)$), dem Ankoppelwiderstand ($R_a$) und dem Messwiderstand ($R_m$);
   **dass** der Sensor (CT)

eine Übertragungsstrecke (30) zur Transformation des jeweiligen Sekundärstroms ($i_{ca}(t)$, $i_{cb}(t)$) in ein zeitdiskretes Ausgangssignal ($y_a(k)$, $y_b(k)$),

eine Hilfswicklung (26) des Messstromwandlers (20) und eine von einem DA-Umsetzer (29) gesteuerte Stromquelle (28) zur Einspeisung eines nachgebildeten Zweigstroms ($i_b(t)$) und

eine CT-Auswerteelektronik (50) umfasst,

wobei die CT-Auswerteelektronik (50) ausgelegt ist zur Aufzeichnung eines realen Ausgangssignals ($y_a(k)$) und eines nachgebildeten Ausgangssignals ($y_b(k)$),

zur Berechnung des nachgebildeten Zweigstroms ($i_b(t)$) aus der Zweigspannung ($u_c(t)$), der zeitlichen Ableitung ($d(u_c(t))/dt$) der Zweigspannung ($u_c(t)$), einem Isolationswiderstand ($R_f$) des zu überwachenden Leitungszweiges (4) und aus einer Ableitkapazität ($C_e$) des zu überwachenden Leitungszweiges (4),

zur Berechnung der Fehlerquadratsumme zwischen dem realen Ausgangssignal ($y_a(k)$) und dem nachgebildeten Ausgangssignal ($y_b(k)$) in der CT-Auswerteelektronik (50)

zur Übermittlung des Isolationswiderstands ($R_f$) und der Ableitkapazität (Ce) an das Isolationsüberwachungsgerät (IMD), falls die Fehlerquadratsumme hinreichend klein ist,

zur Neuberechnung von Schätzwerten für den Isolationswiderstand ($R_f$) und für die Ableitkapazität ($C_e$),

und **dass** zwischen dem Isolationsüberwachungsgerät (IMD) und dem Sensor (CT) eine Kommunikationsverbindung (70) angeordnet ist zum Senden eines Startsignals, zur Übermittlung der Zweigspannung ($u_c(t)$) und zur Übermittlung des Isolationswiderstands ($R_f$) und der Ableitkapazität ($C_e$).

7. Elektrische Schaltungsanordnung (10) nach Anspruch 6,
**dadurch gekennzeichnet,**
**dass** die Übertragungsstrecke (30) einen Bürdenwiderstand (32), ein Tiefpassfilter (34), einen Verstärker mit variabler Verstärkung (36) und einen AD-Umsetzer (38) aufweist.

8. Elektrische Schaltungsanordnung (10) nach Anspruch 6 oder 7,
**dadurch gekennzeichnet,**
**dass** der Messstromwandler (20) zum Messen des Zweigstroms ($i_a(t)$, $i_b(t)$) allstromsensitv ausgeführt ist.

9. Elektrische Schaltungsanordnung (10) nach einem der Ansprüche 6 bis 8,
**dadurch gekennzeichnet,**
**dass** die von der Messspannungsquelle (44) erzeugte periodische Messspannung (ug(t)) aus bipolaren rechteckförmigen Messimpulsen zusammengesetzt ist.

10. Elektrische Schaltungsanordnung (10) nach einem der Ansprüche 6 bis 8,
**dadurch gekennzeichnet,**
**dass** die Hilfswicklung (26) des Messstromwandlers (20) als von dem Messstromwandler (20) separierbare Wicklung ausgeführt ist.

**Claims**

1. A method for determining resistive and capacitive, insulation-determining variables ($R_f$, $C_e$) in a selected branch of a branched ungrounded power supply system (2) using insulation monitoring, the method comprising the following steps:

switching on a periodic measuring voltage ($u_g(t)$) by means of an insulation monitoring device (IMD) which is connected between at least one active conductor (L1) and ground (PE) and has a measuring path (42) having a measuring-voltage source (44), having a coupling resistor ($R_a$) and having at least one measuring resistor ($R_m$) having IMD evaluation electronics (46),

sending a start signal (St) via a communication connection (70) from the insulation monitoring device (IMD) to a sensor (CT), which is disposed in a line branch (4) to be monitored of the ungrounded power supply system (2),

measuring and recording a measured voltage ($u_m(t)$) dropping at the measuring resistor ($R_m$),

measuring a real branch current ($i_a(t)$), which is driven by the measuring voltage ($u_g(t)$), in the sensor (CT) via a real secondary current ($i_{ca}(t)$), which is set in a secondary winding (24), by means of a measuring current transformer (20) having a toroid (22) and the secondary winding (24),

transforming the real secondary current ($i_{ca}(t)$) into a time-discrete real output signal ($y_a(k)$) by means of a transmission path (30) in the sensor (CT),

recording the real output signal ($y_a(k)$) in CT evaluation electronics (50) of the sensor (CT),

switching off the measuring voltage ($u_g(t)$) in the insulation monitoring device (IMD) in accordance with a pre-determinable period number,

computing a branch voltage ($u_c(t)$) from the measuring voltage ($u_g(t)$), the measured voltage ($u_m(t)$), the coupling resistor ($R_a$) and the measuring resistor ($R_m$) in the IMD evaluation electronics (46), transmitting the branch voltage ($u_c(t)$) from the insulation monitoring device (IMD) to the sensor (CT) of the line branch (4) to be monitored by means of the communication connection (70),

computing a simulated branch current ($i_b(t)$) from the branch voltage ($u_c(t)$), the time derivative ($d(u_c(t))/dt$) of the branch voltage ($u_c(t)$), an insulation resistance ($R_f$) of the line branch (4) to be monitored and a leakage capacitance ($C_e$) of the line branch (4) to be monitored in the CT evaluation electronics (50), respective estimated values being used as the initial value for the insulation resistance ($R_f$) and the leakage capacitance ($C_e$),

supplying the simulated branch current ($i_b(t)$) via the sensor (CT) by means of the measuring current transformer (20) via an auxiliary winding (26) and a power source (28) controlled by a DA converter (29),

measuring the simulated branch current ($i_b(t)$) by means of a simulated secondary current ($i_{cb}(t)$) set in the secondary winding (24) of the measuring current transformer (20),

transforming the simulated secondary current ($i_{cb}(t)$) into a time-discrete simulated output signal ($y_b(k)$) by means of the transmission path (30), and

recording the simulated output signal ($y_b(k)$) in the CT evaluation electronics (50),

switching off the supply of the simulated branch current ($i_b(t)$), computing the error square sum between the real output signal ($y_a(k)$) and the simulated output signal ($y_b(k)$) in the CT evaluation electronics (50),

transmitting the insulation resistance ($R_f$) and the leakage capacitance ($C_e$) as the computation result to the insulation monitoring device (IMD) via the communication connection (70) should the error square sum be sufficiently small,

newly computing estimated values for the insulation resistor ($R_f$) and for the leakage capacitance ($C_e$) in the CT evaluation electronics (50),

starting a new measuring cycle when switching on the measuring voltage ($u_g(t)$) and using the newly computed insulation resistance ($R_f$) and the newly computed leakage capacitance ($C_e$).

2. The method according to claim 1,
   **characterized in that**
   the transformation on the transmission path (30) takes place by tapping the voltage of the corresponding secondary current ($i_{ca}(t)$, $i_{cb}(t)$) at a load resistor (32), low-pass filters (34), variable amplification (36) and analog-to-digital conversion (38).

3. The method according to claim 1 or 2,
   **characterized in that**
   an AC/DC-sensitive measuring current transformer (20) is used for measuring the branch current ($i_a(t)$, $i_b(t)$).

4. The method according to any one of the claims 1 to 3,
   **characterized in that**
   the periodic measuring voltage ($u_g(t)$) is comprised of bipolar square measuring pulses.

5. The method according to any one of the claims 1 to 4,
   **characterized in that**
   a winding separable from the measuring current transformer (20) is used as the auxiliary winding (26) of the measuring current transformer (20).

6. An electric circuit arrangement (10) for determining resistive and capacitive, insulation-determining variables ($R_f$, $C_e$) in a selected branch of a branched ungrounded power supply system (2) using insulation monitoring,

   the electric circuit arrangement (10) consisting of an insulation monitoring device (IMD), which is connected between at least one active conductor (L1) and ground (PE) and has a measuring path (42) having a measuring voltage source (44), having a coupling resistor ($R_a$) and having a measuring resistor ($R_m$) having IMD evaluation electronics (46)

   and of a sensor (CT), which is disposed in a line branch (4) to be monitored of the ungrounded power supply system (2) and has a measuring current transformer (20) having a toroid (22) and a secondary winding (24) in order to measure a branch current ($i_a(t)$, $i_b(t)$) by means of a secondary current ($i_{ca}(t)$, $i_{cb}(t)$), which is set in the secondary winding (24),

   the insulation monitoring device (IMD) is configured for switching on a periodic measuring voltage ($u_g(t)$)

generated by the measuring voltage source (44) and for switching off the measuring voltage ($u_g(t)$) after a pre-determinable period number and

for measuring and recording a measured voltage ($u_m(t)$) dropping at the measuring resistor ($R_m$),
**characterized in that**
the IMD evaluation electronics (46) are configured

for computing a branch voltage ($u_c(t)$) from the measuring voltage ($u_g(t)$), the measured voltage ($u_m(t)$), the coupling resistor ($R_a$) and the measuring resistor ($R_m$),
**in that** the sensor (CT) comprises

a transmission path (30) for transforming the corresponding secondary current ($i_{ca}(t)$, $i_{cb}(t)$) into a time-discrete output signal ($y_a(k)$, $y_b(k)$),

an auxiliary winding (26) of the measuring current transformer (20) and a power source (28) controlled by a DA converter (29) in order to supply a simulated branch current ($i_b(t)$) and

CT evaluation electronics (50),

the CT evaluation electronics (50) being configured

for recording a real output signal ($y_a(k)$) and a simulated output signal ($y_b(k)$),

for computing the simulated branch current ($i_b(t)$) from the branch voltage ($u_c(t)$), the time derivative ($d(u_c(t))/dt$) of the branch voltage ($u_c(t)$), an insulation resistance ($R_f$) of the line branch (4) to be monitored and from a leakage capacitance ($C_e$) of the line branch (4) to be monitored,

for computing the error square sum between the real output signal ($y_a(k)$) and the simulated output signal ($y_b(k)$) in the CT evaluation electronics (50),

for transmitting the insulation resistance ($R_f$) and the leakage capacitance ($C_e$) to the insulation monitoring device (IMD) should the error square sum be sufficiently small,

for newly computing estimated values for the insulation resistance ($R_f$) and for the leakage capacitance ($C_e$),
and **in that** a communication connection (70) is disposed between the insulation monitoring device (IMD) and the sensor (CT) in order to send a start signal, for transmitting the branch voltage ($u_c(t)$) and for transmitting the insulation resistance ($R_f$) and the leakage capacitance ($C_e$).

7. The electric circuit arrangement (10) according to claim 6, **characterized in that**
the transmission path (30) has a load resistor (32), a low pass filter (34), an amplifier having variable amplification (36) and an AD converter (38).

8. The electric circuit arrangement (10) according to claim 6 or 7, **characterized in that**
the measuring current transformer (20) is configured to be AC/DC sensitive for measuring the branch current ($i_a(t)$, $i_b(t)$).

9. The electric circuit arrangement (10) according to any one of the claims 6 to 8,
**characterized in that**
the periodic measuring voltage ($u_g(t)$) generated by the measuring voltage source (44) is composed of bipolar square measuring pulses.

10. The electric circuit arrangement (10) according to any one of the claims 6 to 8,
**characterized in that**
the auxiliary winding (26) of the measuring current transformer (20) is configured as a winding separable from the measuring current transformer (20).

**Revendications**

1. Procédé pour déterminer des variables ($R_f$, $C_e$) résistives et capacitives, déterminantes pour l'isolation dans une branche sélectionnée d'un système (2) d'alimentation en courant branché non mis à la terre au moyen d'une surveillance d'isolement, le procédé comprenant les étapes suivantes :

   la mise sous tension d'une tension de mesure ($u_g(t)$) périodique au moyen d'un dispositif (IMD) de surveillance d'isolement qui est connecté entre au moins un conducteur (L1) actif et la terre (PE) et qui a un chemin de mesure (42) ayant une source (44) de tension de mesure, ayant une résistance de couplage ($R_a$) et ayant au moins une résistance de mesure ($R_m$) ayant un circuit (46) d'évaluation IMD électronique,
   l'envoi d'un signal de démarrage (St) via une connexion de communication (70) depuis le dispositif (IMD) de surveillance d'isolement vers un capteur (CT), qui est disposé dans une branche de ligne (4) à surveiller du système (2) d'alimentation en courant non mis à la terre,

la mesure et l'enregistrement d'une tension mesurée ($u_m(t)$) chutant au niveau de la résistance de mesure ($R_m$),

la mesure d'un courant de branche ($i_a(t)$) réel, qui est induit par la tension de mesure ($u_g(t)$), dans le capteur (CT) via un courant secondaire ($i_{ca}(t)$) réel, qui est établi dans un enroulement secondaire (24), au moyen d'un transformateur (20) de courant de mesure ayant une bobine d' u toroïdale (22) et l'enroulement secondaire (24),

la transformation du courant secondaire ($i_{ca}(t)$) réel en un signal de sortie ($y_a(k)$) réel discret dans le temps au moyen d'un chemin de transmission (30) dans le capteur (CT),

l'enregistrement du signal de sortie ($y_a(k)$) réel dans l'électronique d'évaluation CT (50) du capteur (CT),

la mise hors tension de la tension de mesure ($u_g(t)$) dans le dispositif (IMD) de surveillance d'isolement conformément à un nombre de périodes prédéterminé,

le calcul d'une tension de branche ($u_c(t)$) à partir de la tension de mesure ($u_g(t)$), de la tension mesurée ($u_m(t)$), de la résistance de couplage ($R_a$) et de la résistance de mesure ($R_m$) dans l'électronique d'évaluation IMD (46),

la transmission de la branche de tension ($u_c(t)$) du dispositif (IMD) de surveillance d'isolement au capteur (CT) de la branche de ligne (4) à surveiller au moyen de la connexion de communication (70),

le calcul d'un courant de branche ($i_b(t)$) simulé à partir de la tension de branche ($u_c(t)$), de la vitesse d'évolution ($d(u_c(t))/dt$) de la tension de branche ($u_c(t)$), d'une résistance d'isolement ($R_f$) de la branche de ligne (4) à surveiller et d'une capacité de fuite ($C_e$) de la branche de ligne (4) à surveiller dans l'électronique d'évaluation CT (50), les valeurs estimées respectives étant utilisées comme valeur initiale pour la résistance d'isolement ($R_f$) et la capacité de fuite ($C_e$),

la fourniture du courant de branche ($i_b(t)$) simulé par le capteur (CT) au moyen du transformateur (20) de courant de mesure par un enroulement auxiliaire (26) et une source de courant (28) commandée par un convertisseur numérique-analogique (29),

la mesure du courant de branche ($i_b(t)$) simulé au moyen d'un courant secondaire ($i_{cb}(t)$) simulé établi dans l'enroulement secondaire (24) du transformateur (20) de courant de mesure,

la transformation du courant secondaire ($i_{cb}(t)$) simulé en un signal de sortie ($y_b(k)$) simulé discret dans le temps au moyen du chemin de transmission (30), et

l'enregistrement du signal de sortie ($y_b(k)$) simulé dans l'électronique d'évaluation CT (50),

la mise hors tension de l'alimentation du courant de branche ($i_b(t)$) simulé,

le calcul de la somme quadratique des erreurs entre le signal de sortie ($y_a(k)$) réel et le signal de sortie ($y_b(k)$) simulé dans l'électronique d'évaluation CT (50),

la transmission de la résistance d'isolement ($R_f$) et de la capacité de fuite ($C_e$) comme résultat du calcul au dispositif (IMD) de surveillance d'isolement par la connexion de communication (70) si la somme quadratique des erreurs est suffisamment faible,

le calcul à nouveau des valeurs estimées pour la résistance d'isolement ($R_f$) et pour la capacité de fuite ($C_e$) dans l'électronique d'évaluation CT (50),

le démarrage d'un nouveau cycle de mesure lors de la mise sous tension de la tension de mesure ($u_g(t)$) et en utilisant la résistance d'isolement ($R_f$) calculée à nouveau et la capacité de fuite ($C_e$) calculée à nouveau.

2. Procédé selon la revendication 1,
   **caractérisé en ce que**
   la transformation sur le chemin de transmission (30) s'effectue par prélèvement de la tension du courant secondaire ($i_{ca}(t)$, $i_{cb}(t)$) correspondant au niveau d'une résistance de charge (32), de filtres passe-bas (34), d'une amplification variable (36) et d'une conversion analogique-numérique (38).

3. Procédé selon la revendication 1 ou la revendication 2,
   **caractérisé en ce**
   **qu'**un transformateur (20) de courant de mesure sensible à tous les courants est utilisé pour mesurer le courant de branche ($i_a(t)$, $i_b(t)$).

4. Procédé selon l'une quelconque des revendications 1 à 3,
   **caractérisé en ce que**
   la tension de mesure ($u_g(t)$) périodique est constituée d'impulsions de mesure carrées bipolaires.

5. Procédé selon l'une quelconque des revendications 1 à 4,
   **caractérisé en ce**
   **qu'**un enroulement séparable du transformateur (20) de courant de mesure est utilisé comme enroulement auxiliaire (26) du transformateur (20) de courant de mesure.

6. Agencement de circuit (10) électrique pour déterminer des variables résistives et capacitives, déterminantes pour l'isolation ($R_f$, $C_e$) dans une branche sélectionnée d'un système (2) d'alimentation en courant branché non mis à la terre au moyen d'une surveillance d'isolement, l'agencement de circuit (10) électrique comprenant

un dispositif (IMD) de surveillance d'isolement qui est connecté entre au moins un conducteur actif (L1) et la terre (PE) et a un chemin de mesure (42) ayant une source (44) de tension de mesure, ayant une résistance de couplage ($R_a$) et ayant une résistance de mesure ($R_m$) ayant un dispositif électronique d'évaluation IMD (46) et un capteur (CT) qui est disposé dans une branche de ligne (4) à surveiller du système (2) d'alimentation en courant non mis à la terre et un transformateur (20) de courant de mesure ayant une bobine toroïdale (22) et un enroulement secondaire (24) afin de mesurer un courant de branche ($i_a(t)$, $i_b(t)$) au moyen d'un courant secondaire ($i_{ca}(t)$, $i_{cb}(t)$), qui est établi dans l'enroulement secondaire (24),
le dispositif (IMD) de surveillance d'isolement est configuré
pour mettre en tension une tension de mesure ($u_g(t)$) périodique générée par la source (44) de tension de mesure et pour mettre hors tension la tension de mesure ($u_g(t)$) après un nombre de périodes prédéterminé et
pour mesurer et enregistrer une tension mesurée ($u_m(t)$) chutant à la résistance de mesure ($R_m$),
**caractérisé en ce que**
l'électronique d'évaluation IMD (46) est configurée
pour calculer une tension de branche ($u_c(t)$) à partir de la tension de mesure ($u_g(t)$), de la tension mesurée ($u_m(t)$), de la résistance de couplage ($R_a$) et de la résistance de mesure ($R_m$) ;
**en ce que** le capteur (CT) comprend
un chemin de transmission (30) pour transformer le courant secondaire ($i_{ca}(t)$, $i_{cb}(t)$) correspondant en un signal de sortie ($y_a(k)$, $y_b(k)$) discret dans le temps,
un enroulement auxiliaire (26) du transformateur (20) de courant de mesure et une source de courant (28) commandée par un convertisseur numérique-analogique (29) afin de fournir un courant de branche ($i_b(t)$) simulé et
une électronique d'évaluation CT (50),
l'électronique d'évaluation CT (50) étant configurée
pour enregistrer un signal de sortie ($y_a(k)$) réel et un signal de sortie ($y_b(k)$) simulé,
pour calculer le courant de branche ($i_b(t)$) simulé à partir de la tension de branche ($u_c(t)$), de la vitesse d'évolution ($d(u_c(t))/dt$) de la tension de branche ($u_c(t)$), d'une résistance d'isolement ($R_f$) de la branche de ligne (4) à surveiller et d'une capacité de fuite ($C_e$) de la branche de ligne (4) à surveiller,
pour calculer la somme quadratique des erreurs entre le signal de sortie ($y_a(k)$) réel et le signal de sortie ($y_b(k)$) simulé dans l'électronique d'évaluation CT (50),
pour transmettre la résistance d'isolement ($R_f$) et la capacité de fuite ($C_e$) au dispositif (IMD) de surveillance d'isolement si la somme quadratique des erreurs est suffisamment faible,
pour calculer à nouveau les valeurs estimées de la résistance d'isolement ($R_f$) et de la capacité de fuite ($C_e$), et **en ce qu'**une connexion de communication (70) est disposée entre le dispositif (IMD) de surveillance d'isolement et le capteur (CT) afin d'envoyer un signal de démarrage, afin de transmettre la tension de branche ($u_c(t)$) et afin de transmettre la résistance d'isolement ($R_f$) et la capacité de fuite ($C_e$).

7. Agencement de circuit (10) électrique selon la revendication 6, **caractérisé en ce que**
le chemin de transmission (30) a une résistance de charge (32), un filtre passe-bas (34), un amplificateur à amplification (36) variable et un convertisseur analogique-numérique (38).

8. Agencement de circuit (10) électrique selon la revendication 6 ou la revendication 7,
**caractérisé en ce que**
le transformateur (20) de courant de mesure est configuré pour être sensible à tous les courants pour mesurer le courant de branche ($i_a(t)$, $i_b(t)$).

9. Agencement de circuit (10) électrique selon l'une quelconque des revendications 6 à 8,
**caractérisé en ce que**
la tension de mesure ($u_g(t)$) périodique générée par la source (44) de tension de mesure est composée d'impulsions de mesure carrées bipolaires.

10. Agencement de circuit (10) électrique selon l'une quelconque des revendications 6 à 8,
**caractérisé en ce que**
l'enroulement auxiliaire (26) du transformateur (20) de courant de mesure est configuré comme enroulement séparable du transformateur (20) de courant de mesure.

Fig. 1

Fig. 2

**Fig. 3**

EP 4 369 008 B1

Fig. 4

EP 4 369 008 B1

# Fig. 5

```
        ┌─────────┐                                    ┌─────────┐
        │  Start  │                                    │  Start  │
        └────┬────┘                                    └────┬────┘
             │                                              │
    ┌────────┴────────┐                            ┌────────┴────────┐
    │                 │                            │                 │
  ┌─┴──────────┐                       St        ┌─┴──────────────┐
  │   ug(t)    │ ..............................> │  ia(t) als      │
  │ einschalten│                                  │  ica(t)         │
  └─────┬──────┘                                  │  messen, ya(k)  │
        │                                         │  aufzeichnen    │
        ▼                                         └────────┬────────┘
  ┌────────────┐                                           ▼
  │ um(t) messen,│ <.......                       ┌─────────────────┐
  │  aufzeichnen │        :                       │   ib(t)         │
  └─────┬──────┘          :              ........> │  berechnen      │
        │                 :              :         │  (Gl. 1.3, 1.4) │
        ▼                 :              :         └────────┬────────┘
  ┌────────────┐          :              :                  ▼
  │   ug(t)    │          :              :         ┌─────────────────┐
  │ abschalten │          :              :         │   ib(t)         │
  └─────┬──────┘          :              :         │ einschalten     │
        │                 :              :         └────────┬────────┘
        ▼                 :              :                  ▼
  ┌────────────┐   uc(t)  :              :         ┌─────────────────┐
  │  uc(t)     │..........               :         │  ib(t) als      │
  │ berechnen  │                         :         │  icb(t)         │
  │  (Gl. 1.1) │                         :         │  messen, yb(k)  │
  └────────────┘                         :         │  aufzeichnen    │
                                                   └────────┬────────┘
                                                            ▼
                                                   ┌─────────────────┐
                                                   │   ib(t)         │
                                                   │ abschalten      │
                                                   └─────────────────┘
```

$u_g(t)$ einschalten

$u_m(t)$ messen, aufzeichnen

$u_g(t)$ abschalten

$u_c(t)$ berechnen (Gl. 1.1)

St

$u_c(t)$

$i_a(t)$ als $i_{ca}(t)$ messen, $y_a(k)$ aufzeichnen

$i_b(t)$ berechnen (Gl. 1.3, 1.4)

$i_b(t)$ einschalten

$i_b(t)$ als $i_{cb}(t)$ messen, $y_b(k)$ aufzeichnen

$i_b(t)$ abschalten

$R_f$, $C_e$ neu berechnen

Ergebnis $R_f$, $C_e$ ausgeben/ übermitteln

Fehlerquadrat- summe berechnen

EP 4 369 008 B1

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1589345 A1
- DE 102017209663 B3
- DE 102017217473 B3
- DE 102013218836
- DE 102015216915 A1